# EUROPEAN PATENT APPLICATION

(11) **EP 4 617 056 A1**
(43) Date of publication of application: **17.09.2025**
(21) Application number: 25160367.6
(22) Date of filing: 26.02.2025
(51) Int. Cl.: B32B 27/08, B32B 27/34, B32B 27/36, F16L 11/04, H01L 23/473, B32B 1/08, B32B 27/28, B32B 27/30, B32B 27/40

(54) **TUBE FOR REFRIGERANT IN SERVER COOLING APPLICATIONS**

(30) Priority: 14.03.2024 US 202463565075 P; 08.08.2024 US 202463680849 P
(71) Applicant: Parker-Hannifin Corporation, Cleveland, OH 44124-4141 (US)
(72) Inventor: POWELL, Steven M., Cleveland, 44124-4141 (US); HENRY, Ty, Cleveland, 44124-4141 (US); HORINGER, Joseph J., Cleveland, 44124-4141 (US)
(74) Representative: Murgitroyd & Company

(57) **Abstract**

An example tube includes: an inner layer that allows flow of coolant therethrough, wherein the inner layer is made of a polymer material including polyamide, copolyester, polyvinylidene fluoride, or polyvinylidene difluoride, and wherein the inner layer reduces a rate of permeation of coolant; and an outer layer surrounding and bonded to the inner layer, wherein the outer layer is made of copolyester, polyether block amide, or thermoplastic polyurethane.

## Description

### CROSS REFERENCE TO RELATED APPLICATION

The present application claims priority to U.S. Provisional Patent Application No. 63/565,075, filed on March 14, 2024, and U.S. Provisional Patent Application No. 63/680,849, filed on August 8, 2024, the entire contents of all of which are herein incorporated by reference as if fully set forth in this description.

### BACKGROUND

Advanced computer chips in servers generate a substantial amount of heat (e.g., 1000 to 1500 Watts). This heat must be efficiently removed to prevent damage to the chips. As such, these chips require thermal management to control temperature within tight bounds.

Cooling such chips has evolved from natural convection, to forced air, to forced chilled air, to liquid cooling. In single-phase liquid cooling, the refrigerant or coolant (fluid) remains in its liquid form during the entire cooling process. Recently, two-phase cooling has been increasingly used in cooling electronic components. In two-phase cooling, the coolant undergoes a phase change and becomes a gas.

Two-phase cooling may offer several advantages in that the refrigerants are configured to operate at low pressures (e.g., less than 2 MPa or 300 pound per square inch (psi)), and have boiling points below the maximum rated continuous operating chip temperatures (e.g., 65°C). By matching the boiling point of the refrigerant with the maximum continuous operating temperature of the chip, maximum thermal transfer can be achieved. However, two-phase cooling also has challenges.

Fluid lines such as hoses or tubes are used to transfer refrigerant (liquid or gas) between various components of a two-phase cooling system. For example, tubes may be used on the server blade holding a chip, the server blade racking, and for other fluid conveyance needs.

Two-phase cooling may require the use of refrigerants that have global warming potential if leaked to the environment. It may thus be desirable to use tubes that prevent leakage of such harmful gases and prevent refrigerant permeation losses. Particularly, two-phase coolants currently used include highly fluorinated olefins (HFPOs), and such refrigerants can affect many elastomers through absorption, and may thus degrade tube materials over time, which could cause leakage. It may thus be desirable to have tubes configured to resist such chemical degradation. Further, tubes are typically connected to fittings, and it may thus be desirable to provide a no-leak seal with such fittings.

It may also be desirable to have a tube that provides sufficient strength and creep resistance to enhance the life span of the tube. Further, conventional hoses/tubes can be heavy and bulky rubber tubes with polyamide barrier layers typically comprised of Nylon 6, 66 or derivatives. Such tubes might not be suitable for electronic components cooling systems. It may thus be desirable to have tubes that provide flexibility and small bend radius to be able to route such tubes among different components in tight spaces.

It is with respect to these and other considerations that the disclosure made herein is presented.

### SUMMARY

The present disclosure describes implementations that relate to a tube for refrigerants in server cooling applications.

In a first example implementation, the present disclosure describes a tube including: an inner layer configured to allow flow of coolant therethrough, wherein the inner layer is made of a polymer material including polyamide, copolyester, polyvinylidene fluoride, or polyvinylidene difluoride (PVDF), and wherein the inner layer reduces a rate of permeation of coolant; and an outer layer surrounding and bonded to the inner layer, wherein the outer layer is made of copolyester, polyether block amide (PEBA), or thermoplastic polyurethane (TPU), wherein the outer layer has a modulus of elasticity that is an order of magnitude lower than a respective modulus of elasticity of the inner layer.

In a second example implementation, the present disclosure also describes a method of making or using the tube of the first example implementation.

In a third example implementation, the present disclosure also describes an assembly of the tube of the first example implementation with a barbed fitting.

In a fourth example implementation, the present disclosure also describes a server system having a server blade with a plurality of electronic chips mounted thereto, and the tube of the first example implementation used to transfer refrigerant between the electronic chips.

The foregoing summary is illustrative only and is not intended to be in any way limiting. In addition to the illustrative aspects, implementations, and features described above, further aspects, implementations, and features will become apparent by reference to the figures and the following detailed description.

### BRIEF DESCRIPTION OF THE FIGURES

The novel features believed characteristic of the illustrative examples are set forth in the appended claims. The illustrative examples, however, as well as a preferred mode of use, further objectives and descriptions thereof, will best be understood by reference to the following detailed description of an illustrative example of the present disclosure when read in conjunction with the accompanying Figures.
Figure 1 illustrates a partial view of a server system having a server blade with electronic chips mounted thereto and cooling tubes for transfer of coolant, according to an example implementation.
Figure 2A illustrates a side view of a tube, according to an example implementation.
Figure 2B illustrates a front view of the tube of Figure 2A, according to an example implementation.
Figure 3 illustrates a side view of a barbed fitting, according to an example implementation.
Figure 4 illustrates a cross-sectional side view of an assembly of the tube of Figures 2A-2B100 and the barbed fitting of Figure 3, according to an example implementation.
Figure 5 illustrates a side view of an assembly of the barbed fitting of Figure 3 and a tube having a reinforcement layer, according to an example implementation.
Figure 6 is a flowchart of a method of making and/or using a tube, according to an example implementation.

### DETAILED DESCRIPTION

Within examples, disclosed herein is a tube that provides chemical compatibility with refrigerants used in cooling in server applications. The disclosed tube provides enhanced permeation resistance, minimized bend radius for easier routing, suitability with single-phase liquid coolant, two-phase medium -pressure refrigerants, and two-phase low-pressure refrigerants, leak-free connection to barbed fittings, and an enhanced life span (e.g., 5-7 year life).

In an example, the disclosed tube has a two-layer configuration that provides enhanced flexibility and a small bend radius. Particularly, the disclosed tube has an inner wetted surface that is unaffected by two-phase refrigerants, thereby enhancing chemical resistance of the tube to such refrigerants. The inner layer of the disclosed tube includes a polymeric material with particular target wall thickness, modulus of elasticity, tensile strength, and elongation at break, thus providing sufficient strength, creep resistance, and stability to provide a no leak seal with barbed fittings. The inner layer polymer may also provide negligible refrigerant permeation losses.

The outer layer has particular target wall thickness, modulus of elasticity, tensile strength, and elongation at break such that the outer layer provides protection to the inner layer, kink resistance, suitability for thermal forming and bending, and flame retardancy. In an example, the outer layer material has a substantially lower modulus of elasticity than the inner layer to enhance flexibility of the tube or hose.

In one example, the two-layer tube can be used for transfer of two-phase refrigerants having low pressures, e.g., below 1 MPa (100 psi) (such as 0.4 MPa (60 psi)). In another example, it may be desirable to use the tube for transfer of single-phase refrigerants having high pressures (e.g., 3 MPa (250 psi)). In this example, it may be desirable to add a reinforcement layer to the two-layer construction.

In one implementation, the reinforcement layer can be radially interposed between the inner layer and the outer layer. In this implementation, the reinforcement layer has gaps to allow for direct bonding between the outer layer and the second layer. In another implementation, the reinforcement layer can be embedded in the outer layer.

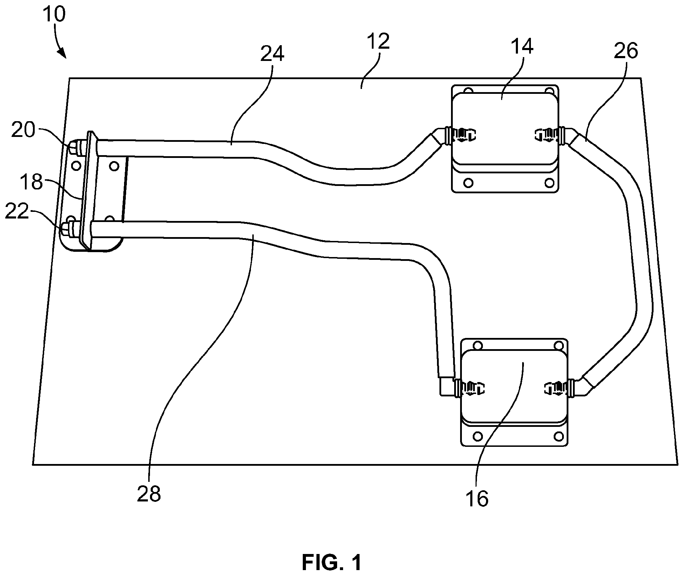

Figure 1 illustrates a partial view of a server system 10 having a server blade 12 with electronic chips mounted thereto and cooling tubes for transfer of coolant, according to an example implementation. The terms "coolant" and "refrigerant" are used interchangeably herein.

A blade server used in data centers, for example, may include a chassis, or box-like structure, housing multiple thin, modular electronic circuit boards, known as server blades such as the server blade 12. Thus, the server blade 12 can be a thin, modular electronic circuit board that is part of a blade server. Blade servers are compact and configured to use minimal space and energy to be suitable for use in high-capacity environments like cloud data centers to fit as many servers as possible into a single rack.

In the illustrative implementation shown in Figure 1, electronic chip 14 and electronic chip 16 (e.g., representing microprocessors, memory, application specific integrated circuits (ASIC), etc.) are mounted to the server blade 12. The term "electronic chip" is used herein to encompass the electronic components and a housing or container in which the electronic components are disposed.

The electronic chips 14, 16 generate a large amount of heat during operation. To protect the electronic chips 14, 16 and the server system 10 generally, it may be desirable to cool the server blade 12 and reduce the operating temperatures of the electronic chips 14, 16.

It may be particularly desirable to use refrigerant systems involving single-phase or two-phase coolants to efficiently and effectively cool the server system 10. As shown in Figure 1, a bracket 18 may be mounted to the server blade 12. The bracket 18 may have a first outward fitting 20 and a second outward fitting 22.

The outward fittings 20, 22 can operate as an inlet and outlet port, respectively, for example. Particularly, the outward fittings 20, 22 facilitate connecting a source of coolant or refrigerant to the server system 10 to absorb heat from the electronic chips 14, 16, and also transfer heated refrigerant away from the electronic chips 14, 16 to another portion of the refrigeration system.

The bracket 18 also has inward fittings to facilitate connecting hoses or tubes between the bracket 18 and the electronic chips 14, 16. For example, a first tube 24 connects the bracket 18 to the electronic chip 14, a second tube 26 connects the electronic chip 14 to the electronic chip 16, and a third tube 28 connects the electronic chip 16 back to the bracket 18, thus forming a loop. This way, refrigerant provided to the server system 10 can flow through the various components to absorb heat generated therefrom, and is then discharged from the server system 10.

For the tubes 24-28 to be effective in cooling the server system 10, it may be desirable that they have particular properties. For example, the tubes 24-28 have low permeation (or have high permeation resistance) to prevent leakage of environmentally harmful refrigerants flowing through the tubes 24-28. The tubes 24-28 are also chemically compatible with the various types of refrigerants to be used in this application. It may also be desirable to prevent the tubes 24-28 from contaminating the refrigerant flowing therethrough (e.g., avoid using chemicals that can leech out of the inner layer of the tubes 24-28 when subjected to refrigerants).

Further, in such server application, hundreds or thousands of server blades may be used, with correspondingly thousands of tube-fitting connections to make. It may thus be desirable to use barbed fittings to facilitate connecting tubes to the various components of the server system 10 in a quick, effective, leak-free manner, without having to torque or crimp the fittings. As such, the tubes 24-28 are configured to form effective, leak-free connections with barbed fittings.

Also, it may be desirable to configure the tubes 24-28 to be flame resistant to protect the valuable components of the server system 10 from fire in the case of a thermal runaway event. Further, as demonstrated in Figure 1, the tubes 24-28 are to be used in tight spaces in a server system environment, and are expected to be bent at various angles (e.g., 45 or 90 degree angles). Thus, it may be desirable to configure the tubes 24-28 to be flexible and capable of thermal forming, while being kink-resistant.

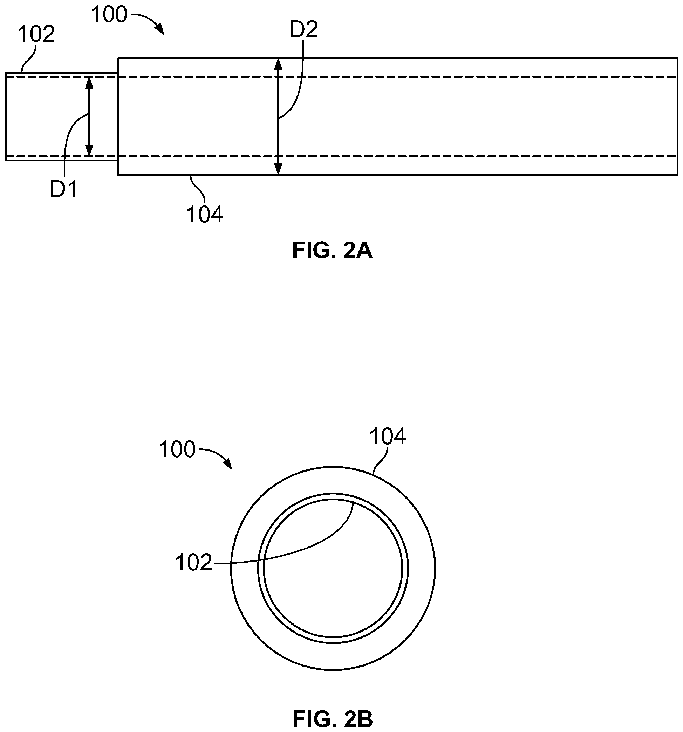

Figure 2A illustrates a side view of a tube 100, and Figure 2B illustrates a front view of the tube 100, according to an example implementation. The tube 100 represents any of the tubes 24-28, for example, and is configured for use in a server application such as the server system 10 described above. As shown, the tube 100 has an inner layer 102 and an outer layer 104 surrounding the inner layer 102.

The inner layer 102 is configured as a tubular member allowing flow of coolant therethrough. Thus, the inner layer 102 can be referred to as the wetted surface as it interacts or is subjected to the refrigerant flowing through the tube 100.

In an example, the inner layer 102 includes a semi-rigid polymer material that has both chemical resistance to refrigerants and low permeation with HFPOs. Particularly, the inner layer 102 is made of a material that is not susceptible to leeching to prevent chemicals from contaminating refrigerants flowing through the tube 100. The wall thickness of the inner layer 102 can be optimized to provide a negligible permeation rate and sufficient structure to form a leak-free coupling to a fitting (e.g., a barbed fitting).

If the inner layer 102 has a wall that is too thin, the permeation rate may be significant and/or the tube 100 might not adequately grip and seal properly with a fitting. Also, it might not be capable of withstanding a particular burst pressure load for which tubes in server system are configured.

On the other hand, if the inner layer 102 has a wall that is too thick, the tube 100 may be stiff and difficult to route within tight space. As such, in an example, a target wall thickness for the inner layer 102 can be between 0.5 millimeter (mm) to 1 mm. As a particular example, the inner layer 102 may have a thickness of 0.5 mm.

The inner layer 102 can be made of a material that achieves particular target physical properties. As examples, the inner layer 102 can be made of polymers including polyamide, copolyester, polyvinylidene fluoride or polyvinylidene difluoride (PVDF). PVDF is a highly nonreactive thermoplastic fluoropolymer produced by the polymerization of vinylidene difluoride, and may provide enhanced thermal, mechanical, electrical, and chemical resistance characteristics.

Other example materials are contemplated. For example, the inner layer 102 can be made of un-plasticized polyamide material (e.g., removing plasticizer content from the polyamide material) to enhance permeation resistance. In another example, a more crystalline polyamide material could be used such as polyamide (PA)610, PA612, or PA6.

In some examples, the inner layer 102 can be multi-layered. For instance, the inner layer 102 can be made of two or more sublayers that have similar modulus of elasticity and can be co-extruded to form the inner layer 102. In some applications, the refrigerant used are not hydroscopic, and do not absorb water. Some refrigerants might be hydroscopic. So, in some applications, it may be desirable to have a moisture barrier sublayer in the inner layer 102. In this example, a first sublayer (e.g., the innermost layer) can be a moisture-blocking sublayer. For instance, the first sublayer can be made of a poly olefin material. In one example, maleic anhydride, which is an organic compound) can be added to the first sublayer to facilitate or enhance bonding with other sublayers of the inner layer 102 during extrusion. A second sublayer, which surrounds the first sublayer, can be a high permeation resistance polymers such as PA612, PA610 or PA6.

With such materials and configurations, the inner layer 102 can be configured to have a target modulus of elasticity between 483 and 2413 MPa (70,000 and 350,000 psi). The inner layer 102 can also be configured to have a greater than 100% elongation at break, and may also have 38-62 MPa (5,500-9,000 psi) tensile strength at break. Materials at the higher end of these ranges may have lower permeation rates and can enable having a small thickness (e.g., between 0.5 mm and 1 mm) for the inner layer 102. As an example, these materials and configuration can achieve a target permeation rate for the tube 100 that is less than 1.5 kilogram per square meter per year (kg/m^2/Yr). This target permeation rate is based on the surface area of the inner layer 102 and measured at the maximum operating temperature and pressure.

The inner diameter "D1" labelled in Figure 2A can vary based on the application. However, it is contemplated that the inner diameter D1 is between 6.5 mm and 9.5 mm.

With this configuration, the inner layer 102 is the primary structural strength material that provides a primary sealing surface for the tube 100. The inner layer 102 also operates as a fitting retention layer and a permeation resistant layer.

The outer layer 104 may constitute the bulk of the material of the tube 100. The outer layer 104 is configured to meet particular tube burst, flexibility, bend radius, kink resistance, and flame retardancy requirements of server cooling applications.

Also, the material of the outer layer 104 has processing conditions suitable for co-extrusion with the polymeric material of the inner layer 102 (the wetted layer/surface). Particularly, in an example, the material of the outer layer 104 has substantially the same processing temperatures (e.g., substantially the same melting temperatures) of the inner layer 102 such that the melt temperature or viscosities of both layers are sufficiently adequate for extrusion at the same time. The term "substantially the same melting temperature" indicates respective melting temperatures that are within 15 degrees Celsius of each other.

The outer layer 104 can be made of a material that achieves particular target physical properties. As examples, the outer layer 104 can be made of a polymeric material such as PA12, copolyester, Thermoplastic Vulcanizate (TPV), polyether block amide (PEBA), which is a thermoplastic elastomer (TPE), or thermoplastic polyurethane (TPU).

With such material, the outer layer 104 can be configured to have a target modulus of elasticity between 21 and 345 MPa (3,000 and 50,000 psi). The outer layer 104 can also be configured to have a greater than 400% elongation at break, and may also have 21-38 MPa (3,000-5,500 psi) tensile strength at break. As such, the material of the outer layer 104 has a modulus of elasticity that is substantially lower (e.g., an order of magnitude or 2-20 times lower) than a respective modulus of elasticity of the inner layer 102. This enhances flexibility of the tube 100.

It is contemplated that the thickness of the outer layer 104 is between 0.5 mm and 1.25 mm. This way, the total thickness of the tube 100 is between 1.5 mm and 1.75 mm. In other words, if the inner diameter D1 of the inner layer 102 is between 6.5 mm and 9.5 mm, then the outer diameter D2 of the outer layer 104 can be between 9.5 mm and 13 mm.

Further, the outer layer 104 is bondable to the inner layer 102 with or without using an adhesive therebetween.

Further, the outer layer 104 includes a flame retardant. For example, the outer layer 104 may include brominated flame retardants. Other suitable flame retardants include Diethyl-N,N-bis(2-hydroxy ethyl)aminomethyl phosphate, Melamine, Pntaerythritol, Triphenyl phosphate, Decabromodiphenyl oxide, Magnesium hydroxide, Antimony(III) oxide, Zinc borate, Melamine polyphosphate, Aluminium hydroxide, Tert-Butylphenyl phenyl phosphate, Isodecyl diphenyl phosphate, Pentabromodiphenyl oxide, 1,2-Bis(tetrabromophthalimido) ethane, Melamine cyanurate, Melamine phosphate, Diisodecyl Diphenyl Phosphate, Tert-butyl triphenyl phosphate, Tri(2-chloroisopropyl)phosphate, Di-tert butylphenyl phenyl phosphate, Ammonium Polyphosphate, Tetrabromophthalate diol, Tri-(p-tert-butylphenyl)phosphate, Triethyl phosphate, 1,2-Bis(perbromophenyl)ethane, Chlorinated Paraffin, Bis(hexachlorocyclopentadieno)cyclooctane .

In some examples, the outer layer 104 can also be configured to be multilayered (e.g., multiple sublayers that are co-extruded together to form the outer layer 104). For example, the outer layer 102 can be composed or can include a polyamide sublayer capable of bonding with the inner layer 102 (or the outermost sublayer of the inner layer 102), and can include another sublayer made of a flexible (e.g., a thermoplastic elastomer or other material that is much more flexible layer compared to the inner layer 102 such that modulus of elasticity is an order of magnitude or 2-20 times lower than that of the inner layer 102 as described above). In an example, a third sublayer (e.g., outermost layer) of the outer layer 104 can be a flame retardant sublayer made of any of the flame retardant materials described above. In some examples, rather than having a separate flame retardant sublayer, the flame retardant material can be included in the other sublayers of the outer layer 104.

With this configuration, the outer layer 104 is configured as a flame retardant layer that provides the bulk of the tube 100 for kink resistance and capable of bending in tight spaces (has small bend radius, e.g., less than 50 mm bend radius).

Thus, the tube 100 is configured to provide permeation resistance, kink resistance, suitability for thermal forming and bending, and flame retardancy characteristics. The tube 100, and particularly the inner layer 102, also provides sufficient structure to form a leak-free coupling to a barbed fitting, which is suitable for server cooling applications.

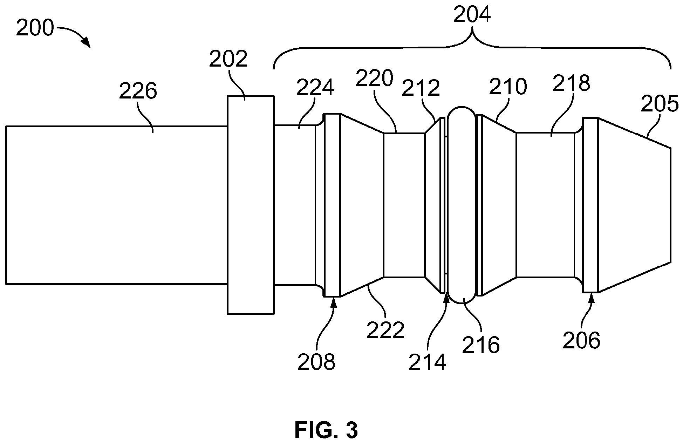

Figure 3 illustrates a side view of a barbed fitting 200, according to an example implementation. The barbed fitting 200 is configured as a generally cylindrical body having a head portion or flange 202 and a barbed portion 204 extending axially from the flange 202. An outer diameter of the barbed portion 204 is smaller than the outer diameter of the flange 202. The barbed fitting 200 can be made of a metal or plastic material.

The term "barb" is used generally herein to indicate a ridge or bump that is configured to grip the inside of the inner layer 102 of the tube 100 to form a seal between the barbed fitting 200 and the tube 100.

The barbed portion 204 of the barbed fitting 200 has a tapered end 205. The barbed portion 204 also includes a distal barb 206 and a proximal barb 208.

Between the distal barb 206 and the proximal barb 208, the barbed portion 204 has a first conical portion 210 and a second conical portion 212. The first conical portion 210 and the second conical portion 212 are tapered in opposite directions such that an annular groove 214 is formed therebetween. The barbed fitting 200 includes a radial seal 216 (e.g., an O-ring) disposed in the annular groove 214.

The barbed portion 204 also includes a first intermediate straight portion 218 interposed between the distal barb 206 and the first conical portion 210. The barbed portion 204 similarly includes a second intermediate straight portion 220 that separates, or is interposed between, the second conical portion 212 and the proximal barb 208. Also, a ramp 222 connects the second intermediate straight portion 220 to the proximal barb 208. A proximal straight portion 224 separates, or is interposed between, the flange 202 and the proximal barb 208. The barbed fitting 200 can also include a proximal cylindrical portion 226 that can be connected to a manifold, a bracket (e.g., the bracket 18), an electronic chip (e.g., the electronic chip 14 or the electronic chip 16), etc.

The tapered end 205 facilitates mounting the tube 100 to the barbed fitting 200 (or inserting the barbed fitting 200 into the tube 100).

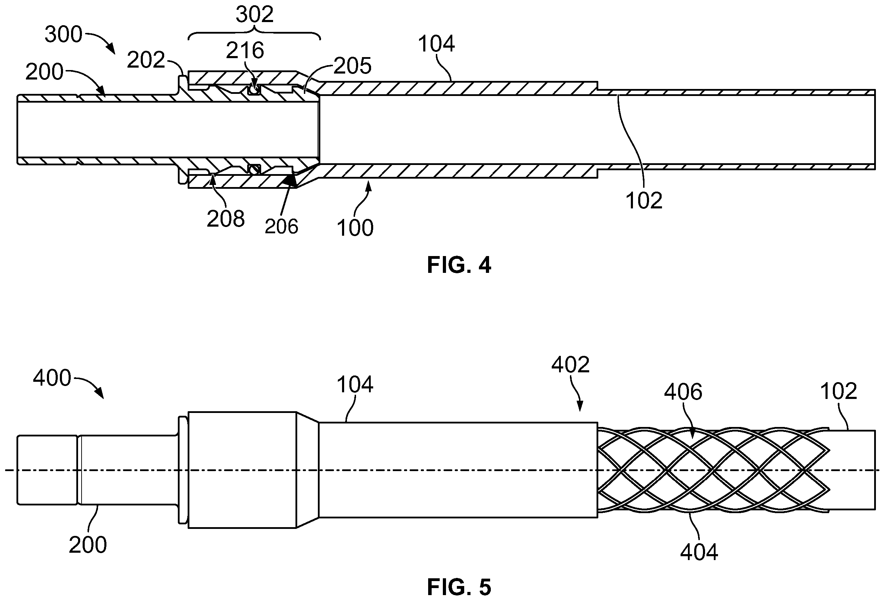

Figure 4 illustrates a cross-sectional side view of an assembly 300 of the tube 100 and the barbed fitting 200, according to an example implementation. As the tube 100 is mounted onto the barbed fitting 200, the tube 100 is sufficiently flexible to enlarge as shown in Figure 4 depicting end portion 302 of the tube 100 being enlarged to accommodate the barbed portion 204 of the barbed fitting 200 therein. The tube 100 can be advanced axially (or the barbed fitting 200 can be inserted axially) until the flange 202 reaches the end of the tube 100 as shown in Figure 4.

With the properties of the inner layer 102 and the outer layer 104 described above, the tube 100 is flexible to accommodate the barbed fitting 200 therein, and the inner layer 102 is also sufficiently strong to retain the barbed fitting 200 via interaction with the distal barb 206 and the proximal barb 208.

Particularly, the barbs 206, 208 have sharp edges to facilitate gripping the interior peripheral surface of the inner layer 102 of the tube 100 and enhance retention of the tube 100 to the barbed fitting 200. An outer diameter of the barbs 206, 208 is based on the size (e.g., the inner diameter of the inner layer 102) of the tube 100. The outer diameter of the barbs 206, 208 can be configured for optimal compression of the layers of the tube 100 to enhance sealing, without compromising the layers of the tube 100. Also, this interaction between the inner layer 102 and the barbs 206, 208, and additionally the radial seal 216, form a durable sealed connection to prevent leakage of refrigerant to an external environment. Further, as mentioned above, the permeation loss through the inner layer 102 is negligible or minimal.

At the same time, the outer layer 104 provides protection to the inner layer 102 and flame retardancy characteristics. The outer layer 104 also provides kink resistance, while allowing the tube 100 to be flexible enough to bend in tight spaces.

In some applications, the tube 100 may be subjected to high refrigerant pressures (e.g., 2 MPa (250 psi)). For instance, in applications involving single-phase coolants, the coolant may be pressurized to such high pressure levels. In these applications, it may be desirable to add a reinforcement layer to the tube 100.

Figure 5 illustrates a side view of an assembly 400 of the barbed fitting 200 and a tube 402, according to an example implementation. The tube 402 is similar to the tube 100, but may additionally have a reinforcement layer 404. As shown, the reinforcement layer 404 can be configured as a braid or oppositely-wound (e.g., helically-wrapped spiral) wires.

The reinforcement layer 404 can be configured as wire made of a metal such as steel, carbon steel, which may be galvanized or corrosion resistant stainless steel (CRES), aluminum, nickel, copper, brass, brass plated steel, zinc or zinc-plated metallic material, a blend, alloy, or other combination thereof. In another example, the reinforcement layer 404 can be made of a polymeric material (e.g., polyester).

Notably, the reinforcement layer 404 is a non-continuous layer. In other words, the reinforcement layer 404 has gaps such as gap 406 due to the construction of the reinforcement layer 404. Such gaps allow for direct bonding between the outer layer 104 and the inner layer 102.

In the example implementation of Figure 5, the reinforcement layer 404 is radially interposed between the outer layer 104 and the inner layer 102. However, in other example implementations, the reinforcement layer 404 can be embedded in the outer layer 104. For example, during formation of the tube 100, the reinforcement layer 404 can be mounted to the outer layer 104, and when the outer layer 104 is heated during extrusion, the reinforcement layer 404 may "sink" into the outer layer 104 to be embedded therein.

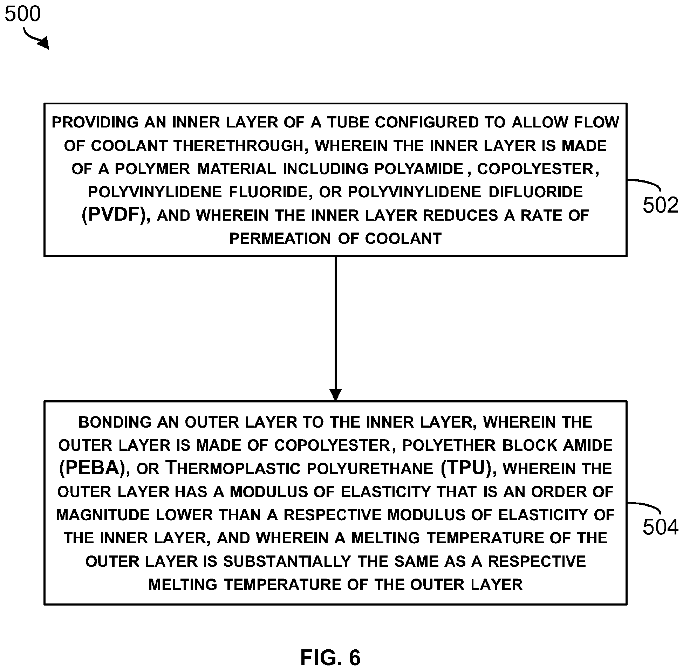

Figure 6 is a flowchart of a method 500 of making and/or using a tube, according to an example implementation. For example, the method 500 can be used for making the tube 100, 402 and for using the tube 100, 402 in the assembly 300, 400 or the server system 10.

The method 500 may include one or more operations, or actions as illustrated by one or more of blocks 502-504. Although the blocks are illustrated in a sequential order, these blocks may in some instances be performed in parallel, and/or in a different order than those described herein. Also, the various blocks may be combined into fewer blocks, divided into additional blocks, and/or removed based upon the desired implementation.

At block 502, the method 500 includes providing the inner layer 102 of the tube 100, 402 configured to allow flow of coolant therethrough, wherein the inner layer 102 is made of a polymer material including polyamide, copolyester, polyvinylidene fluoride, or polyvinylidene difluoride (PVDF), and wherein the inner layer 102 reduces a rate of permeation of coolant. The term "providing" as used herein, and for example with regard to the inner layer 102 or other components, includes any action to make the inner layer 102 or any other component available for use, such as bringing the inner layer 102 to an apparatus or to a work environment for further processing (e.g., mounting other components, forming the outer layer 104 or the reinforcement layer 404, etc.).

At block 504, the method 500 includes bonding the outer layer 104 to the inner layer 102, wherein the outer layer 104 is made of copolyester, polyether block amide (PEBA), or thermoplastic polyurethane (TPU), wherein the outer layer 104 has a modulus of elasticity that is an order of magnitude lower than a respective modulus of elasticity of the inner layer, and wherein a melting temperature of the outer layer is substantially the same as a respective melting temperature of the outer layer.

The method 500 can further include any of the steps or operations described above. For example, the method 500 can include melting the inner layer 102 and the outer layer 104, then coextruding both layers to form the tube 100, 402. The method 500 can include mounting the reinforcement layer 404, such that reinforcement layer 404 is interposed between the inner layer 102 and the outer layer 104, or embedded within the outer layer 104.

The method 500 may also include mounting the tube 100, 402 to the barbed fitting 200, and/or using the tube 100, 402 in the server system 10 for coolant transfer.

The detailed description above describes various features and operations of the disclosed systems with reference to the accompanying figures. The illustrative implementations described herein are not meant to be limiting. Certain aspects of the disclosed systems can be arranged and combined in a wide variety of different configurations, all of which are contemplated herein.

Further, unless context suggests otherwise, the features illustrated in each of the figures may be used in combination with one another. Thus, the figures should be generally viewed as component aspects of one or more overall implementations, with the understanding that not all illustrated features are necessary for each implementation.

Additionally, any enumeration of elements, blocks, or steps in this specification or the claims is for purposes of clarity. Thus, such enumeration should not be interpreted to require or imply that these elements, blocks, or steps adhere to a particular arrangement or are carried out in a particular order.

Further, devices or systems may be used or configured to perform actuators presented in the figures. In some instances, components of the devices and/or systems may be configured to perform the actuators such that the components are actually configured and structured (with hardware and/or software) to enable such performance. In other examples, components of the devices and/or systems may be arranged to be adapted to, capable of, or suited for performing the actuators, such as when operated in a specific manner.

By the term "substantially" or "about" it is meant that the recited characteristic, parameter, or value need not be achieved exactly, but that deviations or variations, including for example, tolerances, measurement error, measurement accuracy limitations and other factors known to those with skill in the art, may occur in amounts that do not preclude the effect the characteristic was intended to provide.

The arrangements described herein are for purposes of example only. As such, those skilled in the art will appreciate that other arrangements and other elements (e.g., machines, interfaces, operations, orders, and groupings of operations, etc.) can be used instead, and some elements may be omitted altogether according to the desired results. Further, many of the elements that are described are functional entities that may be implemented as discrete or distributed components or in conjunction with other components, in any suitable combination and location.

While various aspects and implementations have been disclosed herein, other aspects and implementations will be apparent to those skilled in the art. The various aspects and implementations disclosed herein are for purposes of illustration and are not intended to be limiting, with the true scope being indicated by the following claims, along with the full scope of equivalents to which such claims are entitled. Also, the terminology used herein is for the purpose of describing particular implementations only, and is not intended to be limiting.

Embodiments of the present disclosure can thus relate to one of the enumerated example embodiments (EEEs) listed below.
EEE 1 is a tube comprising: an inner layer configured to allow flow of coolant therethrough, wherein the inner layer is made of a polymer material including polyamide, copolyester, polyvinylidene fluoride, or polyvinylidene difluoride (PVDF), and wherein the inner layer reduces a rate of permeation of coolant; and an outer layer surrounding and bonded to the inner layer, wherein the outer layer is made of copolyester, polyether block amide (PEBA), or thermoplastic polyurethane (TPU), wherein the outer layer has a modulus of elasticity that is an order of magnitude lower than a respective modulus of elasticity of the inner layer.
EEE 2 is the tube of EEE 1, wherein the inner layer has an inner diameter in a range between 6.5 millimeter (mm) and 9.5 mm.
EEE 3 is the tube of any of EEEs 1-2, wherein the inner layer has a modulus of elasticity in a range between 70,000 and 350,000 pound per square inch (psi).
EEE 4 is the tube of any of EEEs 1-3, wherein the inner layer has a tensile strength in a range between 5,500 and 9,000 psi.
EEE 5 is the tube of any of EEEs 1-4, wherein the inner layer has a greater than 100% elongation at break.
EEE 6 is the tube of any of EEEs 1-5, wherein the inner layer has a thickness in a range between 0.5 mm and 1 mm.
EEE 7 is the tube of any of EEEs 1-6, wherein the outer layer has a modulus of elasticity in a range between 3,000 and 50,000.
EEE 8. The tube of any of EEEs 1-7, wherein the outer layer has a tensile strength in a range between 3,000 and 5,500 psi.
EEE 9 is the tube of any of EEEs 1-8, wherein the outer layer has a greater than 400% elongation at break.
EEE 10 is the tube of any of EEEs 1-9, wherein a total thickness of the tube is between 1.5 mm and 1.7 mm.
EEE 11 is the tube of any of EEEs 1-10, further comprising: a reinforcement layer.
EEE 12 is the tube of EEE 11, wherein the reinforcement layer is interposed between the inner layer and the outer layer, wherein the reinforcement layer has a plurality of gaps to allow for direct bonding between the outer layer and the inner layer.
EEE 13 is the tube of EEE 11, wherein the reinforcement layer is embedded into the outer layer.
EEE 14 is an assembly comprising: the tube of any of EEEs 1-13 and a barbed fitting inserted into the tube. For example, the tube comprises: (i) an inner layer configured to allow flow of coolant therethrough, wherein the inner layer is made of a polymer material including polyamide, copolyester, polyvinylidene fluoride, or polyvinylidene difluoride (PVDF), and wherein the inner layer reduces a rate of permeation of coolant, and (ii) an outer layer surrounding and bonded to the inner layer, wherein the outer layer is made of copolyester, polyether block amide (PEBA), or thermoplastic polyurethane (TPU), wherein the outer layer has a modulus of elasticity that is an order of magnitude lower than a respective modulus of elasticity of the inner layer; and the barbed fitting comprises: (i) a flange interfacing with an end of the tube, (ii) a barbed portion extending axially from the flange, wherein the barbed portion includes a distal barb and a proximal barb, wherein the distal barb and the proximal barb grip the inner layer of the tube, (iii) an annular groove formed between the distal barb and the proximal barb, and (iv) a radial seal mounted to the annular groove.
EEE 15 is the assembly of EEE 14, wherein the inner layer has an inner diameter in a range between 6.5 millimeter (mm) and 9.5 mm, a modulus of elasticity in a range between 70,000 and 350,000 pound per square inch (psi), a tensile strength in a range between 5,500 and 9,000 psi, a greater than 100% elongation at break, and a thickness in a range between 0.5 mm and 1 mm.
EEE 16 is the assembly of any of EEEs 14-15, wherein the outer layer has a modulus of elasticity in a range between 3,000 and 50,000, a tensile strength in a range between 3,000 and 5,500 psi, a greater than 400% elongation at break, and wherein a total thickness of the tube is between 1.5 mm and 1.7 mm.
EEE 17 is the assembly of any of EEEs 14-16, wherein the tube further comprises: a reinforcement layer, wherein (i) the reinforcement layer is interposed between the inner layer and the outer layer, wherein the reinforcement layer has a plurality of gaps to allow for direct bonding between the outer layer and the inner layer, or (ii) the reinforcement layer is embedded into the outer layer.
EEE 18 is a server system comprising: a server blade; a plurality of electronic chips mounted to the server blade; and a plurality of tubes connected the plurality of electronic chips and configured to transfer refrigerant to and from the plurality of electronic chips, wherein a tube of the plurality of tubes is the tube of any of EEEs 1-13. For example, the tube comprises: an inner layer configured to allow flow of coolant therethrough, wherein the inner layer is made of a polymer material including polyamide, copolyester, polyvinylidene fluoride, or polyvinylidene difluoride (PVDF), and wherein the inner layer reduces a rate of permeation of coolant, and an outer layer surrounding and bonded to the inner layer, wherein the outer layer is made of copolyester, polyether block amide (PEBA), or thermoplastic polyurethane (TPU), wherein the outer layer has a modulus of elasticity that is an order of magnitude lower than a respective modulus of elasticity of the inner layer.
EEE 19 is the server system of EEE 18, further comprising the barbed fitting of the assembly of any of EEEs 14-17. For example, the barbed fitting comprises: a barbed fitting mounted to an electronic chip of the plurality of electronic chips, wherein the tube is mounted to the barbed fitting, wherein the barbed fitting comprises: (i) a flange interfacing with an end of the tube, (ii) a barbed portion extending axially from the flange, wherein the barbed portion includes a distal barb and a proximal barb, wherein the distal barb and the proximal barb grip the inner layer of the tube, (iii) an annular groove formed between the distal barb and the proximal barb, and (iv) a radial seal mounted to the annular groove.
EEE 20 is the server system of any of EEE 18-19, wherein: the inner layer has an inner diameter in a range between 6.5 millimeter (mm) and 9.5 mm, a modulus of elasticity in a range between 70,000 and 350,000 pound per square inch (psi), a tensile strength in a range between 5,500 and 9,000 psi, a greater than 100% elongation at break, and a thickness in a range between 0.5 mm and 1 mm, and the outer layer has a modulus of elasticity in a range between 3,000 and 50,000, a tensile strength in a range between 3,000 and 5,500 psi, a greater than 400% elongation at break, and wherein a total thickness of the tube is between 1.5 mm and 1.7 mm.
EEE 21 is the tube of any of EEEs 1-13, the assembly of any of EEEs 14-17, or the server system of any of EEEs 18-20, wherein the inner layer is composed of multiple sublayers.
EEE 22 is the tube, assembly, or server system of EEE 21, wherein the multiple layers comprise: a moisture-blocking sublayer surrounded by permeation-resistant sublayer.
EEE 23 is the tube, assembly, or server system of EEE 22, wherein the moisture-blocking sublayer comprises a poly olefin material.
EEE 24 is the tube, assembly, or server system of EEE 23, wherein the moisture-blocking sublayer further comprises maleic anhydride to facilitate bonding to the permeation-resistant layer.
EEE 25 is the tube of any of EEEs 1-13, the assembly of any of EEEs 14-17, or the server system of any of EEEs 18-20, wherein the outer layer is composed of multiple sublayers.
EEE 26 is the tube, assembly, or server system of EEE 25, wherein the outer layer comprises a first sublayer made of a polyamide material to enhance bonding with the inner layer.
EEE 27 is the tube, assembly, or server system of EEE 26, wherein the outer layer further comprises a second sublayer made of a flexible material having a modulus of elasticity that is an order of magnitude lower than a respective modulus of elasticity of the inner layer.
EEE 28 is the tube, assembly, or server system of EEE 27, wherein the outer layer further comprises a third sublayer made of a flame retardant material.

## Claims

1. A tube comprising:
an inner layer configured to allow flow of coolant therethrough, wherein the inner layer is made of a polymer material including polyamide, copolyester, polyvinylidene fluoride, or polyvinylidene difluoride, PVDF, and wherein the inner layer reduces a rate of permeation of coolant; and
an outer layer surrounding and bonded to the inner layer, wherein the outer layer is made of copolyester, polyether block amide, PEBA, or thermoplastic polyurethane, TPU, wherein the outer layer has a modulus of elasticity that is an order of magnitude lower than a respective modulus of elasticity of the inner layer.

2. The tube of claim 1, wherein the inner layer has an inner diameter in a range between 6.5 mm and 9.5 mm.

3. The tube of claim 1 or claim 2, wherein the inner layer has a modulus of elasticity in a range between 483 and 2413 MPa (70,000 and 350,000 psi).

4. The tube of any preceding claim, wherein the inner layer has a tensile strength in a range between 38 and 62 MPa (5,500 and 9,000 psi).

5. The tube of any preceding claim, wherein the inner layer has a greater than 100% elongation at break.

6. The tube of any preceding claim, wherein the inner layer has a thickness in a range between 0.5 mm and 1 mm.

7. The tube of any preceding claim, wherein the outer layer has a modulus of elasticity in a range between 3,000 and 50,000; and/or
wherein the outer layer has a tensile strength in a range between 21 and 38 MPa (3,000 and 5,500 psi).

8. The tube of any preceding claim, wherein the outer layer has a greater than 400% elongation at break.

9. The tube of any preceding claim, wherein a total thickness of the tube is between 1.5 mm and 1.7 mm.

10. The tube of any preceding claim, further comprising:
a reinforcement layer.

11. The tube of claim 10, wherein the reinforcement layer is interposed between the inner layer and the outer layer, wherein the reinforcement layer has a plurality of gaps to allow for direct bonding between the outer layer and the inner layer.

12. The tube of claim 10, wherein the reinforcement layer is embedded into the outer layer.

13. An assembly comprising:
a tube according to any of claims 1 to 12; and
a barbed fitting inserted into the tube, wherein the barbed fitting comprises: (i) a flange interfacing with an end of the tube, (ii) a barbed portion extending axially from the flange, wherein the barbed portion includes a distal barb and a proximal barb, wherein the distal barb and the proximal barb grip the inner layer of the tube, (iii) an annular groove formed between the distal barb and the proximal barb, and (iv) a radial seal mounted to the annular groove.

14. A server system comprising:
a server blade;
a plurality of electronic chips mounted to the server blade; and
a plurality of tubes connected the plurality of electronic chips and configured to transfer refrigerant to and from the plurality of electronic chips, wherein the plurality of tubes comprises a tube according to any of claims 1 to 12.

15. The server system of claim 14, further comprising:
a barbed fitting mounted to an electronic chip of the plurality of electronic chips, wherein the tube is mounted to the barbed fitting, wherein the barbed fitting comprises: (i) a flange interfacing with an end of the tube, (ii) a barbed portion extending axially from the flange, wherein the barbed portion includes a distal barb and a proximal barb, wherein the distal barb and the proximal barb grip the inner layer of the tube, (iii) an annular groove formed between the distal barb and the proximal barb, and (iv) a radial seal mounted to the annular groove.
